# EUROPEAN PATENT APPLICATION

(11) **EP 2 109 148 A2**
(43) Date of publication of application: **14.10.2009**
(21) Application number: 09152104.7
(22) Date of filing: 05.02.2009
(51) Int. Cl.: H01L 31/0224, H01L 31/05

(54) **Wafer level interconnection and method**

(30) Priority: 10.04.2008 US 100447
(71) Applicant: General Electric Company, Schenectady, NY 12345 (US)
(72) Inventor: Burdick, Jr. William Edward, Niskayuna, NY 12309 (US); Erlbaum, Jeffrey Scott, Albany, NY 12203 (US); Nagarkar, Kaustubh Ravindra, Guilderland, NY 12084 (US); Tonapi, Sandeep Shrikant, Chandler, AZ 85248 (US)
(74) Representative: Bedford, Grant Richard

(57) **Abstract**

A semiconductor assembly includes a semiconductor wafer including backside contact pads (15) coupled to respective contact regions of different signal types (40, 42) and insulation (18) separating the backside contact regions by signal type. The semiconductor assembly further includes metallization (36) situated over at least a portion of the insulation and interconnecting the backside contact pads.

## Description

The invention relates generally to semiconductor wafer assemblies and more specifically to photovoltaic (PV) cell assemblies.

Conventional solar panels include PV cells with p type contacts on the backside and n type contacts on the opposing or top side (side facing the sun). These PV cells are electrically interconnected in series to provide the desired size and power for the solar panel. The series connections typically include narrow solder-tinned copper tabs that connect the top side of one PV cell with the backside of the next PV cell. PV cells configured with all backside contact pads eliminate some electrical routing associated with such connections. Backside contact pads can therefore increase the available conversion area on the cell. However, because backside-contacted solar cells have both n type and p type pads in one plane, it is a challenge to route signals and electrically interconnect cells in series without crossing polarities.

To satisfy the manufacturability needs for solar panels constructed with backside contact solar cells and enable high density packaging, an improved interconnect and assembly method would be useful.

Briefly, in accordance with one embodiment of the present invention disclosed herein, a photovoltaic cell assembly comprises: a photovoltaic (PV) cell including backside contact pads coupled to contact regions of differing polarities and insulation separating the backside contact pads by polarity; and metallization situated over at least a portion of the insulation and interconnecting the backside contact pads.

In accordance with another embodiment disclosed herein, a semiconductor assembly comprises: a semiconductor wafer including backside contact pads coupled to respective contact regions of differing signal types and insulation separating the backside contact pads by signal type; and metallization situated over at least a portion of the insulation and interconnecting the backside contact pads.

In accordance with another embodiment disclosed herein, a semiconductor assembly method comprises: providing a semiconductor wafer including backside contact pads coupled to respective contact regions of differing signal types; applying insulation at the wafer level to separate the backside contact pads by signal type; and applying metallization to interconnect the backside contact pads.

Various features, aspects, and advantages of the present invention will become better understood when the following detailed description is read with reference to the accompanying drawings in which like characters represent like parts throughout the drawings, wherein:
FIGs. 1 and 2 illustrate wafer processing stages in accordance with one embodiment disclosed herein.
FIG. 3 illustrates a wafer processing stage in accordance with another embodiment disclosed herein.
FIG. 4 illustrates a top view of an interconnected wafer, and FIG. 5 illustrates a side view in accordance with another embodiment disclosed herein.
FIG. 6 illustrates a simplified side view of a wafer interconnection in accordance with another embodiment disclosed herein.
Fig. 7 illustrates a top view of an interconnected wafer in accordance with another embodiment disclosed herein.

In accordance with embodiments described herein, insulation is used at a wafer (or "cell") level and patterned according to isolation requirements to facilitate later connection at an assembly (or "packaged") level. For example, when used in the context of photovoltaic cells, the dielectric material is applied during cell fabrication.

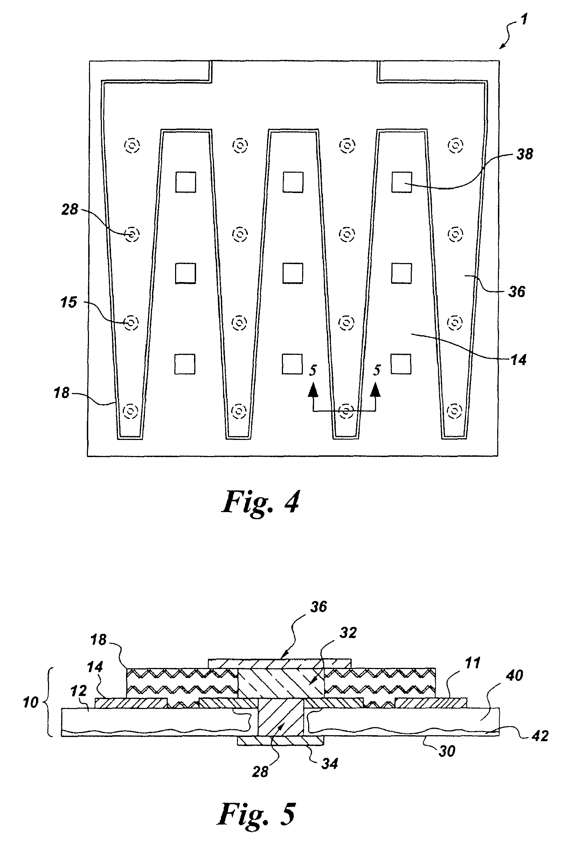

In one example, shown for purposes of illustration in FIGs. 4 and 5, a semiconductor assembly 1 comprises: a semiconductor wafer 10 including contact pads 15 and 38 on a common surface and coupled to respective contact regions 42 and 40 of different signal type and insulation 18 separating the backside contact pads by signal type; and metallization 36 situated over at least a portion of the insulation and interconnecting the backside contact pads. In one more specific embodiment, the contact regions of different signal type are situated on the backside. In another more specific embodiment, the wafer comprises a photovoltaic (PV) cell, the common surface is the backside 11, and the contact regions have different polarities. Although the PV cell embodiment is described in detail for purposes of example, the concepts are additionally applicable to other semiconductor wafer embodiments where signals are received or transmitted on or through one side with multiple polarities or types. One such example is sensor arrays.

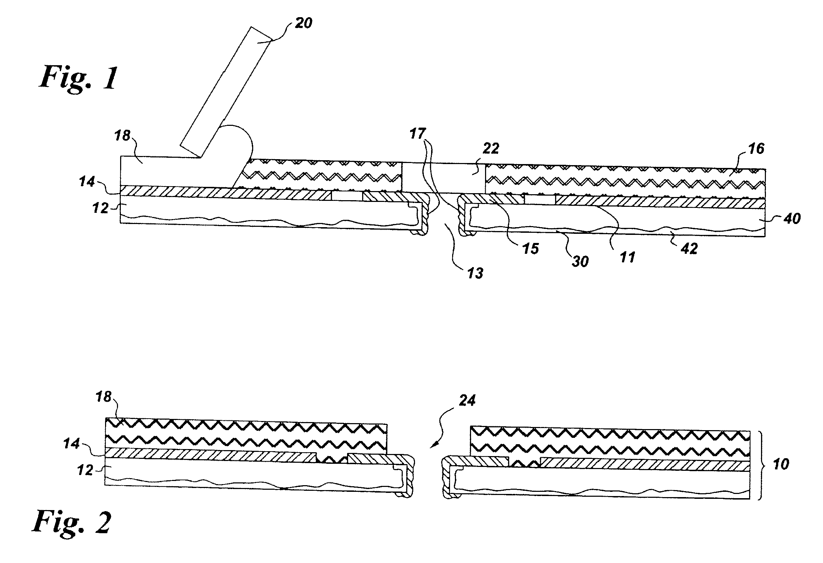

FIGs. 1 and 2 illustrate PV cell 10 level processing stages in accordance with one embodiment described herein. PV cell 10 includes a semiconductor wafer 12 having polarity type regions 40 and 42, electrically conductive trace 14, and contact pads 15 (only one of which is shown for purposes of example in FIGs. 1-2). In one embodiment, regions 40 are p type and regions 42 are n type. FIG. 1 additionally illustrates a via 13 extending from a backside 11 of PV cell 10 to an opposing side 30. Via 13 may optionally be coated or filled with an electrically conductive material 17. In one example, the via diameter is on the order of one millimeter. In another example, the via has a diameter to thickness ratio of 1:1.

Substrate 12 may comprise any appropriate semiconductor material and, in one example, comprises silicon. Electrically conductive trace 14 may comprise any suitable electrically conductive material and, in one embodiment, comprises aluminum. Contact pads 15 may comprise any suitable electrically conductive material with several examples including copper, aluminum, silver, gold, alloys including any of the aforementioned materials, and electrically conductive polymer compositions. Although n type region 42 is shown as extending all the way to backside 11 (and thus providing two polarity regions on the backside), this embodiment is not required. It is possible to provide an electrical connection (not shown in FIG. 1) extending to a polarity region on opposing side 30 through via 13, for example.

FIG. 1 additionally illustrates a screen 16 including a plug 22. In one embodiment, screen 16 comprises a stainless steel or a polymer mesh and plug 22 comprises a material such as a polymer or an epoxy. The screen enables the deposition of insulation 18 with the plug protecting the area of via 13. In one screen-printing embodiment, a tool 20 such as a squeegee is used to apply insulation in a liquid form through screen 16. Insulation 18 may comprise any non-conducting material that is capable of withstanding intended use conditions of the PV cell assembly with several examples including silicones, polyimides, epoxies, and acrylates.

Screen-printing is a fast and inexpensive technique that may be accomplished with commercially available equipment and materials. After printing, as can be seen in FIG. 2, locations of contact pads 15 remain exposed (through openings 24). The printed layer may then be cured in a batch oven to form a solid insulation film. In an alternative embodiment, ultraviolet curing may be used.

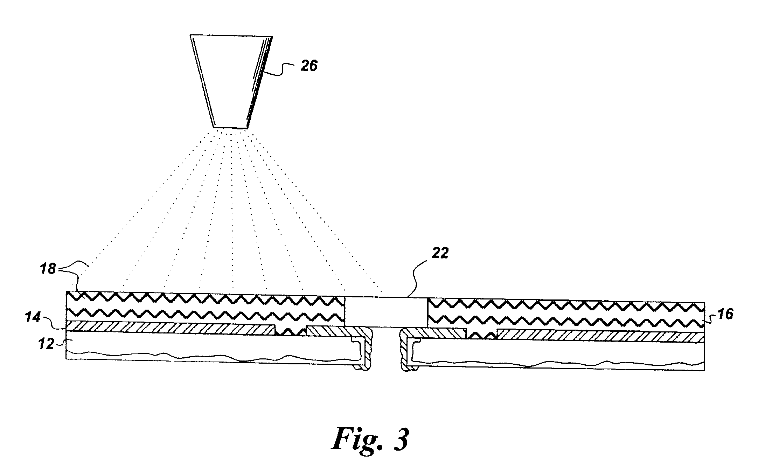

FIG. 3 illustrates a PV processing stage in accordance with another embodiment wherein insulation 18 is applied by a spray coater 26. An optional mask 16 with plugs 22 may be used in a similar manner as discussed with respect to FIG. 1. Spray coating is inexpensive and can be easily integrated in a PV manufacturing facility. Spray coating further facilitates a continuous "in-line" manufacturing process. After coating, insulation may be cured as discussed with respect to FIG. 2 above.

Although several insulation application methods are described with respect to FIGs. 1-3, any appropriate method may be used to apply insulation 18 at the PV cell level with several other examples including deposition and lamination. When lamination is used, such lamination may be with or without an electrically conductive interconnection material on the opposite side of the dielectric layer.

FIG. 4 illustrates a top view of an interconnected PV cell 1, and FIG. 5 illustrates a side view in accordance with another embodiment described herein. If not done so earlier, electrically conductive material is applied to vias 13 of FIG. 1 to create conducive vias 28 extending from backside 11 to opposing side 30 of PV cell 10. This may be accomplished by any appropriate technique with some examples including printing, plugging, and inserting electrically conductive pins. Example materials for electrically conductive vias 28 include copper, silver, and aluminum.

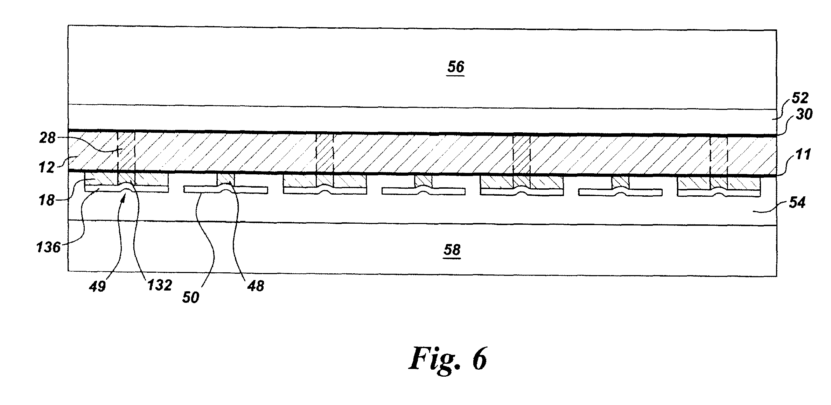

In the embodiment of FIG. 5, backside contact pads 15 are adjacent to electrically conductive vias 28, and insulation 18 surrounds and partially overlaps at least some of the contact pads to facilitate the isolation. An electrically conductive joining material 32 is typically applied between contact pads 15, electrically conductive via 28, and the metallization 36. In one embodiment, electrically conductive joining material 32 comprises a solder or conductive adhesive. In one embodiment, electrically conductive joining material 32 comprises a conductive adhesive composition tailored for simultaneous curing with a module encapsulant (shown in FIG. 6 as encapsulant 52 and 54, for example).

The electrically conductive joining material 32 and electrically conductive via 28 that are coupled to the n type regions 42 require isolation from the p type layer 40 that exists on the majority of the backside surface. Any lack of isolation will result in the shunting of the n type traces with the p type layer of opposite polarity, thereby reducing the efficiency of PV cell 10.

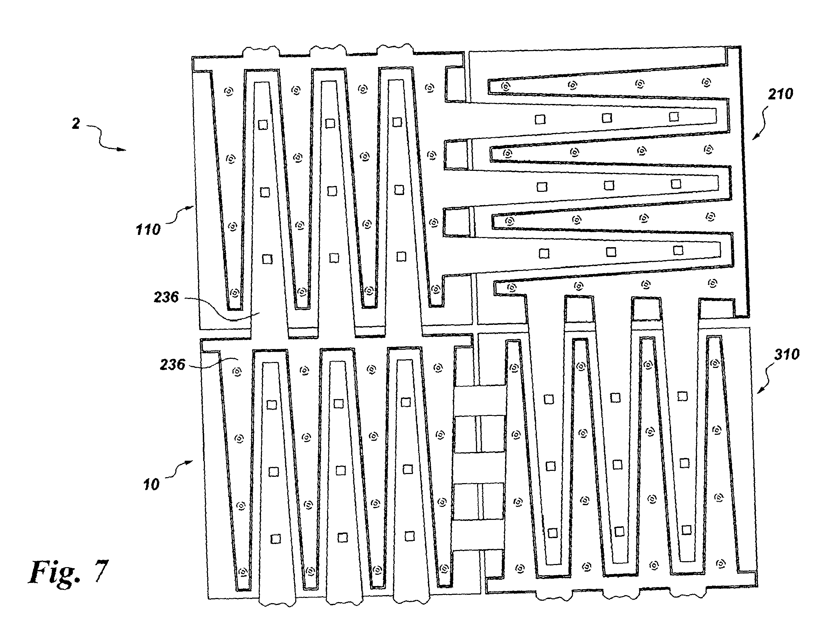

Metallization 36 may comprise any appropriate electrically conductive material. In one embodiment, metallization 36 comprises copper. For ease of illustration, the embodiment of FIG. 4 illustrates a backside view of n type contact pads 15 and p type contact pads 38 but does not illustrate p type contact pad interconnections. Metallization 36 is shown as fanning out to prevent current crowding. Metallization may be applied by any appropriate technique with several examples including printing, sputtering, plating, and, as described below with respect to FIG. 7, use of a pre-patterned sheet.

FIG. 6 illustrates a simplified side view of a wafer interconnection embodiment wherein electrically conductive joining material 132 and metallization 136 form dimples 49. A "dimple" as used herein is meant to encompass any surface that is intentionally "not flat" so as to increase the surface area between the metallization 136 and the electrically conductive joining material 132 and provide increased compliance in the z axis. If desired, the dimple may also be use to facilitate x axis and y axis alignment. The increased surface area is expected to result in reduced contact resistance and greater mechanical strength. Although the dimples in FIG. 6 are shown as being in the direction of the PV cell, dimples 49 may alternatively face away from the PV cell.

FIG. 6 additionally illustrates packaging comprising encapsulant 52 and 54 on opposing sides of substrate 12, glass 56, and back sheet 58. Encapsulant may comprise any structurally and optically suitable material with one example material comprising ethylene-vinyl acetate. Back sheet 58 may comprise any structurally suitable material with several examples including polyvinyl fluorides, polyethylene terephthalate polyesters, ethelyne vinyl acetates, and thermoplastic elastomers.

Fig. 7 illustrates a top view of a PV cell assembly 2 in accordance with another embodiment wherein the PV cell 10 comprises a plurality of PV cells 10, 110, 210, 310 and wherein a portion 236 of the metallization extends over at least two of the plurality of PV cells 10 and 110. In a more specific embodiment, the portion of the metallization extending over at least two of the PV cells comprises a pre-patterned sheet. This embodiment is useful for ease of manufacturing. In the assembly process, joining material 32 (FIG. 5) may be applied either to contact pads 15 and 38 prior to the positioning of the pre-patterned sheet 236, or joining material 32 may be applied to the pre-patterned sheet directly. Patterning may be accomplished by any appropriate technique with several examples including punching, and laser cutting.

Assembly embodiments disclosed herein may be fabricated in accordance with various fabrication techniques. For example, in one embodiment, a semiconductor assembly method comprises: providing a semiconductor wafer 12 including backside contact pads 15 and 28 coupled to regions of differing signal types; applying insulation 18 on the wafer to separate the backside contact pads by signal type; and applying metallization 36 to interconnect the backside contact pads. In a more specific embodiment, the semiconductor wafer comprises a photovoltaic cell comprising p type and n type contacts, and applying the insulation is performed in a manner to separate the p type contacts from the n type contracts.

As discussed above, vias 13 may extend through at least some contact pads of the semiconductor wafer, and electrical conductors may be provided in the vias to result in electrically conductive vias 28. In one embodiment, the electrical conductors are provided after applying insulation 18. Also, as discussed above, the method may further comprise applying an electrically conductive joining material 32 between the electrically conductive vias and the metallization.

In another embodiment wherein the semiconductor wafer comprises a plurality of semiconductor wafers 10, 110, 210, 310 and a portion of the metallization 236 extends over at least two of the plurality of semiconductor wafers, applying the metallization comprises providing a patterned sheet of the metallization, and attaching the patterned sheet over at least two of the semiconductor wafers.

Embodiments described herein have many advantages in that the embodiments enable a highly conductive (low I²R loss), reliable, manufacturable design of wafer level interconnection.

While only certain features of the invention have been illustrated and described herein, many modifications and changes will occur to those skilled in the art. It is, therefore, to be understood that the appended claims are intended to cover all such modifications and changes as fall within the true spirit of the invention.

Various aspects and embodiments of the present invention are now defined in the following numbered clauses:
1. A photovoltaic cell assembly comprising:
   (a) a photovoltaic (PV) cell including backside contact pads coupled to contact regions of different polarities and insulation separating the backside contact pads by polarity; and
   (b) metallization situated over at least a portion of the insulation and interconnecting the backside contact pads.
2. The assembly of clause 1 wherein the PV cell further comprises electrically conductive vias extending from an opposing side to the backside of the PV cell.
3. The assembly of any preceding clause wherein the PV cell comprises p type and n type contacts, and wherein the insulation separates the p type contacts from the n type contracts.
4. The assembly of any preceding clause wherein the insulation surrounds at least some of the backside contact pads.
5. The assembly of any preceding clause further comprising an electrically conductive joining material between the backside contact pads, the electrically conductive vias and the metallization.
6. The assembly of any preceding clause wherein the electrically conductive joining material and the metallization form dimples.
7. The assembly of any preceding clause wherein the PV cell comprises a plurality of PV cells and wherein a portion of the metallization extends over at least two of the plurality of PV cells.
8. The assembly of any preceding clause wherein the portion of the metallization extending over at least two of the PV cells comprises a pre-patterned sheet.
9. A semiconductor assembly comprising:
   a semiconductor wafer including contact pads on a common surface and coupled to respective contact regions of differing signal types and insulation separating the contact pads by signal type; and
   metallization situated over at least a portion of the insulation and interconnecting the contact pads.
10. The semiconductor assembly of clause 9 wherein the semiconductor wafer further comprises electrically conductive vias extending from an opposing side to the common surface of the semiconductor wafer.
11. The semiconductor assembly of clause 9 or 10 wherein the contact pads are adjacent to the electrically conductive vias and wherein the insulation surrounds at least some of the backside contact pads.
12. The semiconductor assembly of any of clauses 9 to 11 further comprising an electrically conductive joining material between the electrically conductive vias, the backside contact pads, and the metallization.
13. The semiconductor assembly of any of clauses 9 to 12 wherein the electrically conductive joining material and the metallization form dimples.
14. The semiconductor assembly of any of clauses 9 to 13 wherein the semiconductor wafer comprises a plurality of semiconductor wafers and wherein a portion of the metallization comprises a pre-patterned sheet and extends over at least two of the plurality of semiconductor wafers.
15. A semiconductor assembly method comprising:
   providing a semiconductor wafer including contact pads on a common surface and coupled to respective contact regions of differing signal types;
   applying insulation at the wafer level to separate the contact pads by signal type; and
   applying metallization to interconnect the contact pads.
16. The method of clause 15 wherein providing the semiconductor wafer comprises providing vias extending through at least some contact pads of the semiconductor wafer.
17. The method of clause 15 or 16 further comprising, after applying insulation, providing electrical conductors in the vias.
18. The method of any of clauses 15 to 17 further comprising applying an electrically conductive joining material between the contact pads, the electrical conductors in the vias, and the metallization.
19. The method of any of clauses 15 to 18 wherein the electrically conductive joining material comprises an electrically conductive adhesive composition, and further comprising encapsulating the semiconductor wafer and the metallization with an encapsulant, and simultaneously curing the electrically conductive adhesive composition and the encapsulant.
20. The method of any of clauses 15 to 19 wherein the semiconductor wafer comprises a plurality of semiconductor wafers and wherein a portion of the metallization extends over at least two of the plurality of semiconductor wafers.
21. The method of any of clauses 15 to 20 wherein applying the metallization comprises
   providing a patterned sheet of the metallization, and
   attaching the patterned sheet over at least two of the semiconductor wafers comprises a pre-patterned sheet.
22. The method of any of clauses 15 to 21 wherein the semiconductor wafer comprises a photovoltaic cell comprising p type and n type contacts, and wherein applying the insulation separates the p type contacts from the n type contracts.

## Claims

1. A photovoltaic cell assembly (1) comprising:
(a) a photovoltaic (PV) cell (10) including backside contact pads (15) coupled to contact regions of different polarities and insulation (18) separating the backside contact pads by polarity; and
(b) metallization (36) situated over at least a portion of the insulation and interconnecting the backside contact pads.

2. The assembly of claim 1 wherein the PV cell (10) further comprises electrically conductive vias (28) extending from an opposing side (30) to the backside (11) of the PV cell.

3. The assembly of any preceding claim wherein the PV cell (10) comprises p type and n type contacts, and wherein the insulation separates the p type contacts from the n type contracts.

4. The assembly (2) of any preceding claim further comprising an electrically conductive joining material (32) between the backside contact pads, the electrically conductive vias and the metallization.

5. The assembly (2) of any preceding claim wherein the electrically conductive joining material and the metallization form dimples (49).

6. The assembly (2) of any preceding claim wherein the PV cell comprises a plurality of PV cells and wherein a portion of the metallization (236) extends over at least two of the plurality of PV cells.

7. The assembly (2) of any preceding claim wherein the portion of the metallization (236) extends over at least two of the PV cells comprises a pre-patterned sheet.

8. A semiconductor assembly (1) comprising:
a semiconductor wafer (10) including contact pads (15) on a common surface and coupled to respective contact regions of differing signal types and insulation (18) separating the contact pads by signal type; and
metallization (236) situated over at least a portion of the insulation and interconnecting the contact pads.

9. A semiconductor assembly method comprising:
providing a semiconductor wafer including contact pads (15) on a common surface and coupled to respective contact regions of differing signal types;
applying insulation (18) at the wafer level to separate the contact pads by signal type; and
applying metallization (236) to interconnect the contact pads.

10. The method of claim 9 further comprising applying an electrically conductive joining material (32) between the contact pads (15), the electrical conductors in the vias, and the metallization, wherein the electrically conductive joining material comprises an electrically conductive adhesive composition, and further comprising encapsulating the semiconductor wafer and the metallization (236) with an encapsulant, and simultaneously curing the electrically conductive adhesive composition and the encapsulant.
